# FASCICULE DE BREVET EUROPEEN

(11) **EP 2 040 291 B1**
(45) Date de publication et mention de la délivrance du brevet: **14.03.2018**
(21) Numéro de dépôt: 08164325.6
(22) Date de dépôt: 15.09.2008
(51) Int. Cl.: H01L 21/58, H01L 27/146, H01L 21/78, H01L 21/683, H01L 31/024, H01L 23/34

(54) **Procédé de collage de puces sur un substrat de contrainte et procédé de mise sous contrainte d'un circuit de lecture semi-conducteur**
Klebeverfahren für Chips auf ein Spannungssubstrat und Verfahren zur Spannungsanlegung an einen Halbleiter-Leseschaltkreis
Method of gluing chips to a constraint substrate and method of placing a semi-conductor reading circuit under constraint

(30) Priorité: 19.09.2007 FR 0757676
(43) Date de publication de la demande: 25.03.2009
(73) Titulaire: Commissariat à l'Énergie Atomique et aux Énergies Alternatives, 75015 Paris (FR)
(72) Inventeur: Fendler, Manuel, 38000, GRENOBLE (FR); Ait-Mani, Abdenacer, 38120, SAINT EGREVE (FR); Gueugnot, Alain, 38360, SASSENAGE (FR); Marion, François, 38950, SAINT-MARTIN LE VINOUX (FR)
(74) Mandataire: Ilgart, Jean-Christophe

(56) Documents cités:
- FR-A- 2 646 018
- FR-A- 2 810 454
- FR-A- 2 857 508
- US-A- 4 943 491
- US-A1- 2002 038 905
- US-A1- 2002 048 906
- US-B1- 6 255 140
- US-B1- 6 407 381

## Description

### DOMAINE TECHNIQUE

L'invention concerne un procédé de collage de puces sur un substrat de contrainte et un procédé de mise sous contrainte d'un circuit de lecture semi-conducteur par un matériau de coefficient de dilatation différent.

### ETAT DE LA TECHNIQUE ANTERIEURE

La fiabilisation thermomécanique d'ensembles hétérogènes, c'est-à-dire constitués de deux parties aux propriétés différentes, par exemple des coefficient de dilatation ou des modules d'Young différents, nécessite l'exploitation d'une structure bilame, voire d'une structure dite BCS (« Balanced Composite Structure »). De telles structures se caractérisent par le collage d'un substrat dit de contrainte sur l'ensemble à fiabiliser.

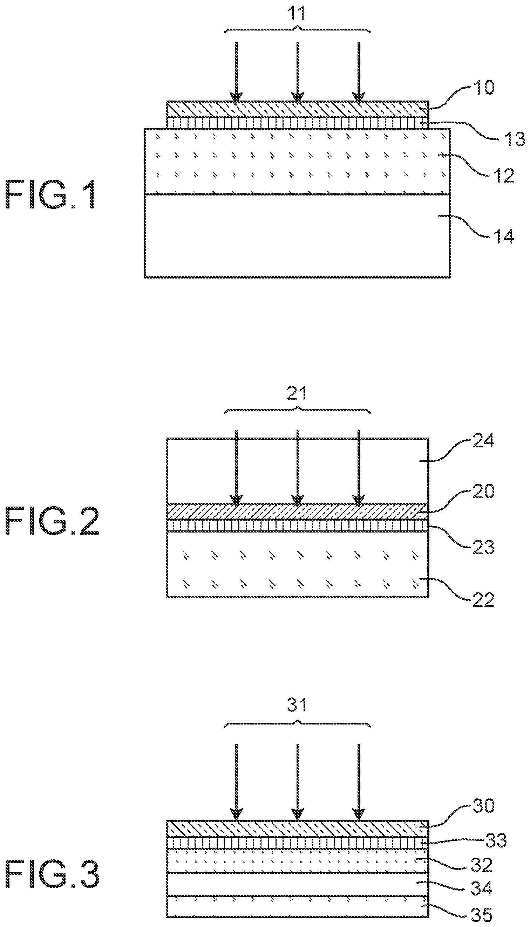

Le document référencé **[1]** en fin de description décrit ainsi un ensemble d'interconnexions entre un circuit de lecture et un plan focal de détection. Cet ensemble, comme illustré sur la figure 1, comprend une première couche 10 en semi-conducteur de détection d'un rayonnement 11 présentant un premier coefficient de dilatation, une seconde couche 12 de multiplexage à circuits électroniques à semi-conducteur présentant un second coefficient de dilatation, une troisième couche 13 d'interconnection située entre les deux premières couches 10 et 12, et un substrat de contrainte 14 présentant un grand coefficient de dilatation collé à la surface inférieure de la seconde couche 12. Ce document décrit une structure fiabilisée « par le bas ».

Le document référencé **[2]** décrit une structure fiabilisée « par le haut ». Comme illustré sur la figure 2, cette structure comprend une couche 20 de détection d'un rayonnement 21, une couche 22 de lecture et une couche 23 d'interconnexion située entre ces deux premières couches 20 et 22. La couche de lecture 22, réalisée en un premier matériau semiconducteur, sert de référence mécanique. Un substrat de contrainte 24, en un second matériau transparent au rayonnement et adapté au premier matériau, est disposé au-dessus des moyens 20 de détection.

Dans ces deux documents, les structures se caractérisent par le collage d'un substrat de contrainte sur l'ensemble à fiabiliser.

Le document référencé **[3]** décrit une structure à réseau plan focal hybride. Comme illustré figure 3, cette structure comprend une couche 30 en semi-conducteur de détection d'un rayonnement incident 31, une couche de multiplexage 32, et une couche 33 d'interconnexion entre ces deux couches 30 et 32. Un substrat de contrainte 34 ayant des caractéristiques mécaniques et géométriques identiques à celles de la couche de détection 30 est collé à la surface inférieure de la couche 32. Une couche supplémentaire 35 ayant des caractéristiques identiques à celles de la couche 32 sert à corriger la courbure de l'ensemble généré par le bilame 32, 34. L'ensemble de ces trois couches 32, 34, 35, formant une structure BCS, permet de fiabiliser l'ensemble. Cette structure est ainsi fiabilisée « par le bas ».

Mais le collage d'un substrat de contrainte sur un ensemble à fiabiliser doit être réalisé avec un film de colle homogène, sans bulle, qui permette un bon couplage mécanique entre les parties assemblées pour profiter pleinement de l'effet bilame.

De nombreux documents de l'art antérieur relatifs aux techniques de collage concernent des traitements de surfaces et leurs propriétés physico-chimiques permettant d'obtenir un bon mouillage et une forte adhérence. Les procédés de collage sont du domaine du savoir-faire. En général, l'absence de bulle et l'homogénéité de collage sont obtenues par dégazage, collage sous vide, centrifugation, bouchonnage ou par application d'importantes pressions. De telles techniques sont difficilement utilisables pour de grandes surfaces, lorsque la tolérance liée à la moindre aspérité et au moindre défaut de collage devient quasi-nulle, ce qui est le cas de la microélectronique.

De plus de telles techniques, par exemple des techniques de dépôt sous vide et d'adhérence moléculaire, qui nécessitent un niveau de propreté extrême (salles blanches aux classes inférieures à 100), sont onéreuses.

Pour pallier de tels inconvénients, l'invention a pour objet un procédé bas coût qui permet d'effectuer un collage collectif de puces individuelles sur un substrat commun, qui s'apparente à un collage grande surface en exploitant tous les avantages d'un collage unitaire petite surface. Un collage collectif des puces sur un substrat de contrainte est décrit dans le document US 2002/048906 A1 (voir les figures 14A-14D, 15A, 15B).

### EXPOSÉ DE L'INVENTION

L'invention concerne un procédé de collage collectif de puces individuelles sur un substrat de contrainte, comprenant les étapes suivantes :
- on dispose des couches fonctionnalisées sur un support, par exemple adhésif, ces couches fonctionnalisées étant disposées de manière adjacente non contiguë avec un espacement e entre deux couches voisines,
- on dépose une goutte de colle calibrée sur chacune de ces couches fonctionnalisées,
- on reporte le substrat de contrainte sur les gouttes de colle,
- on singularise des parties de l'ensemble ainsi formé pour réaliser des puces collées sur le substrat de contrainte,
caractérisé en ce que la colle déposée sur chaque couche fonctionnalisée est une goutte de colle calibrée, et en ce que le substrat présente des évidements au-dessus des espacements "e". Avantageusement, l'espacement "e" est compris entre 40 µm et 500 µm. les couches fonctionnalisées sont réalisées en silicium.

L'invention concerne également un procédé de mise sous contrainte d'un circuit de lecture semiconducteur, par exemple en silicium, par un substrat en un matériau de coefficient de dilatation différent mettant en oeuvre le procédé ci-dessus. Avantageusement, ce matériau est choisi parmi les matériaux suivants : germanium, saphir, BeO.

### BRÈVE DESCRIPTION DES DESSINS

Les figures 1 à 3 illustrent des exemples de réalisation de l'art antérieur.
Les figures 4 à 6 illustrent des exemples de réalisation qui ne comprennent pas toutes les caractéristiques du procédé de l'invention.
La figure 7 illustre le procédé de l'invention.

### EXPOSÉ DÉTAILLÉ DE MODES DE RÉALISATION PARTICULIERS

Le procédé de l'invention est un procédé de collage collectif de puces individuelles sur un substrat commun.

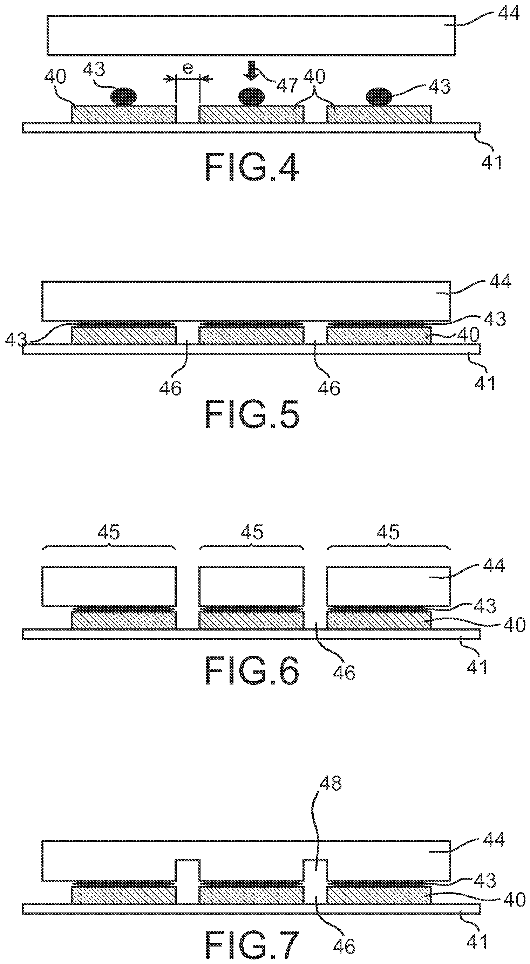

Selon l'exemple illustré sur la figure 4, des couches 40 dites « fonctionnalisées » ou actives, c'est-à-dire intégrant par exemple des circuits de lecture, sont disposées sur un support 41, par exemple adhésif. Dans le cas où ces couches fonctionnalisées 40 présentent une structuration de surface due par exemple à des plots d'interconnexion (par exemple des billes de brasure) pour interconnecter ultérieurement les couches 40 à un autre circuit, les plots sont directement en contact avec le support adhésif 41. Ces couches fonctionnalisées 40 sont disposées de manière adjacente non contiguë, avec un espacement "e" entre elles compris entre 40 µm et 500 µm.

Une goutte de colle calibrée 43 est ensuite déposée sur chacune de ces couches fonctionnalisées.

Un substrat de contrainte 44 est, alors, reporté (flèche 47) sur l'ensemble ainsi formé, ce qui permet d'obtenir la réalisation illustrée sur la figure 5.

Des puces 45 sont alors singularisées en découpant le substrat de contrainte 44 comme illustré sur la figure 6. Ces puces 45 sont ensuite décollées du support 41.

Le procédé de l'invention, comme l'exemple des figures 4 à 6, allie les avantages d'un collage « grande surface », par le traitement simultané de plusieurs puces 45 via le collage d'un substrat de contrainte 44 de grande taille sur des couches fonctionnalisées 40 pré-disposées sur le support 41, avec les avantages du collage unitaire dit « faible surface » permettant d'éviter l'apparition de bulles.

En disposant les couches fonctionnalisées de manière adjacente non contiguë, on crée entre elles des canaux 46 s'apparentant à des réservoirs permettant de piéger localement les bulles. Les bulles chassées vers l'extérieur d'une couche fonctionnalisée 40 n'ont donc pas besoin de parcourir tout le substrat de contrainte 44 pour être évacuées à l'extérieur. Selon le procédé de l'invention, il est possible d'augmenter ces canaux 46 en réalisant dans le substrat de contrainte des évidements 48 situés au-dessus des canaux 46. On a alors la réalisation de la figure 7, à la place de la réalisation de la figure 5. Cela permet entre autre de diminuer les espacements "e" tout en préservant le même volume disponible pour la colle à évacuer.

Le procédé de l'invention est utilisable par exemple pour la mise sous contrainte d'un circuit de lecture en silicium (44) par un substrat en un matériau de coefficient de dilatation différent adapté aux composants à hybrider. Ce peut être, par exemple :
- du germanium sur du silicium dans le cas de détecteurs CdHgTe ou CdTe,
- du saphir sur du silicium dans le cas de détecteurs CdHgTe ou CdTe,
- du BeO sur du silicium dans le cas de détecteurs CdHgTe ou CdTe.

De tels matériaux sont les plus couramment utilisés dans le domaine du rayonnement infrarouge refroidi (CdHgTe) ou du rayonnement X (CdTe). A ces matériaux s'ajoute l'ensemble des matériaux de type métaux, semiconducteurs, céramiques, verres et polymères dont les propriétés thermomécaniques conviennent à l'application visée. On peut citer, dans le cas du CdHgTe, à titre d'exemples non exhaustifs, les matériaux suivants : Mo, CuMoCu, FeNiCo, verres de scellement sur métal, le Cd(Zn)Te massif, etc...

De manière générale, le procédé de l'invention est applicable à toute réalisation d'un bilame (ou d'un assemblage à plus de deux couches, comme décrit dans le document référencé **[3])**, destiné à modifier le comportement thermomécanique d'un substrat, pour adapter des coefficients de dilatation.

Le procédé de l'invention permet ainsi de contraindre tout matériau à épouser le comportement thermomécanique d'un autre matériau en respectant les règles de comportement des bilames.

Le procédé de l'invention peut, plus largement, être appliqué à tout collage multiple de puces ou de matériaux sur une embase : par exemple, le report de puces optiques (InP, GaAs, silice) sur des plateformes d'assemblage silicium (« silicon optical bench »), comme décrit dans le document référencé **[4].** On peut également citer le report de puces sur des embases (puces GaN pour l'éclairage, puces silicium sur céramiques ou fonds de boîtiers, MCM ou « Multi Chip Modules ») ou l'encapsulation (« packaging »), au sens général du terme, comme décrit dans le document référencé **[5]** .

Avantageusement, la signature du procédé collectif, et donc commun à des puces d'un même lot, selon l'invention est aisée à démontrer en ce qui concerne les caractéristiques de collage que sont :
- la nature et épaisseur identique de colle,
- le niveau de réticulation identique,
- la dureté Shore identique.

### REFERENCES

**[1]** US 4,943,491
**[2]** US 5,365,088
**[3]** EP 0 829 907
**[4]** « Die attachment methods » de Leo G. Feinstein (Electronic Materials Handbook, vol. 1 Packaging, ASM International, pp. 213-223, 1989)
**[5]** « Overview of Multichip Technology » de John W. Balder (Electronic Materials Handbook, vol. 1 Packaging, ASM International, pp. 297-312, 1989).

## Revendications

1. Procédé de collage collectif de puces individuelles sur un substrat de contrainte (44), comprenant les étapes suivantes :
- on dispose des couches fonctionnalisées (40) sur un support (41), de manière adjacente non contiguë, avec un espacement (e) entre deux couches (40) voisines,
- on dépose de la colle (43) sur chacune de ces couches fonctionnalisées,
- on reporte le substrat de contrainte (44) sur cette colle,
- on singularise des parties de l'ensemble ainsi formé pour réaliser des puces (45) collées sur le substrat de contrainte,
**caractérisé en ce que** la colle déposée sur chaque couche fonctionnalisée est une goutte de colle (43) calibrée, et **en ce que** le substrat (44) présente des évidements (48) au-dessus des espacements (e).

2. Procédé selon la revendication 1, dans lequel on dispose les couches fonctionnalisées sur un support adhésif (41).

3. Procédé selon la revendication 1, dans lequel l'espacement (e) est compris entre 40 µm et 500 µm.

4. Procédé selon la revendication 1, dans lequel les couches fonctionnalisées (40) sont réalisées en silicium.

5. Procédé de mise sous contrainte d'un circuit de lecture semiconducteur par un substrat en un matériau de coefficient de dilatation différent mettant en oeuvre le procédé selon l'une quelconque des revendications précédentes.

6. Procédé selon la revendication 5, dans lequel le matériau est choisi parmi les matériaux suivants : germanium, saphir, BeO.

## Patentansprüche

1. Verfahren zum kollektiven Kleben von einzelnen Chips auf ein Spannungssubstrat (44), umfassend die nachstehenden Schritte:
- Anordnen von funktionalisierten Schichten (40) auf einen Träger (41) in nicht abstandsfrei aneinandergrenzender Weise mit einem Zwischenraum (e) zwischen den beiden benachbarten Schichten (40),
- Aufbringen von Klebstoff (43) auf jede dieser funktionalisierten Schichten,
- Setzen des Spannungssubstrats (44) auf diesen Klebstoff,
- Vereinzeln von Teilen der so gebildeten Einheit zum Ausbilden von auf das Spannungssubstrat aufgeklebten Chips (45),
**dadurch gekennzeichnet, dass**
der auf jede funktionalisierte Schicht aufgebrachte Klebestoff ein kalibrierter Klebstofftropfen (43) ist und dass das Substrat (44) Ausnehmungen (48) über den Zwischenräumen (e) aufweist.

2. Verfahren nach Anspruch 1, wobei die funktionalisierten Schichten auf einen Haftträger (41) angeordnet werden.

3. Verfahren nach Anspruch 1, wobei der Zwischenraum (e) zwischen 40 µm und 500 µm beträgt.

4. Verfahren nach Anspruch 1, wobei die funktionalisierten Schichten (40) aus Silicium hergestellt sind.

5. Verfahren zum Spannungsanlegen an einen Halbleiter-Leseschaltkreis durch ein Substrat aus einem Material mit anderem Ausdehnungskoeffizienten, welches das Verfahren nach einem der vorangehenden Ansprüche durchführt.

6. Verfahren nach Anspruch 5, wobei das Material ausgewählt ist aus den nachfolgenden Materialien: Germanium, Saphir, BeO.

## Claims

1. Method of collective bonding of individual chips on a strained substrate (44), comprising the following steps:
- functionalised layers (40) are arranged on a support (41), in an adjacent non-contiguous manner, with a space (e) between two neighbouring layers (40),
- the adhesive (43) is deposited on each of these functionalised layers,
- the strained substrate (44) is transferred onto this adhesive,
- parts of the assembly thereby formed are singularised to produce chips (45) bonded on the strained substrate,
**characterised in that** the adhesive deposited on each functionalised layer is a calibrated drop of adhesive (43), and **in that** the substrate (44) has hollows (48) above the spaces (e).

2. Method according to claim 1, in which the functionalised layers are arranged on an adhesive support (41).

3. Method according to claim 1, in which the space (e) is between 40 µm and 500 µm.

4. Method according to claim 1, in which the functionalised layers (40) are formed in silicon.

5. Method of placing under strain a semiconductor reading circuit by a substrate in a material of different coefficient of expansion implementing the method according to any of the previous claims.

6. Method according to claim 5, in which the material is chosen among the following materials: germanium, sapphire, BeO.
